Europäisches Patentamt

European Patent Office

Office européen des brevets

(19)

(11) Publication number: **0 322 902**
**A2**

# EUROPEAN PATENT APPLICATION

(21) Application number: 88121810.1

(22) Date of filing: 28.12.88

(51) Int. Cl.4: **G11C 7/00 , G11C 7/06**

(30) Priority: 28.12.87 JP 332011/87

(43) Date of publication of application:
05.07.89 Bulletin 89/27

(84) Designated Contracting States:
DE FR GB

(71) Applicant: **Matsushita Electric Industrial Co., Ltd.**
**1006, Oaza Kadoma**
**Kadoma-shi Osaka-fu, 571(JP)**

(72) Inventor: **Akamatsu, Hironori**
**Shoto-ryo 5-103, Fujita-cho**
**Moriguchi-shi Osaka(JP)**
Inventor: **Shiragasawa, Tsuyoshi**
**9-16-605, Shimizu-cho**
**Neyagawa-shi Osaka(JP)**
Inventor: **Matsushima, Junko**
**688-3, Kuzumoto-cho**
**Kashihara-shi Nara-ken(JP)**

(74) Representative: **Grupe, Peter, Dipl.-Ing. et al**
**Patentanwaltsbüro**
**Tiedtke-Bühling-Kinne-Grupe-Pellmann-Grams-Struif-Winter-Roth Bavariaring 4**
**D-8000 München 2(DE)**

(54) A Semiconductor memory operating with a low peak current.

(57) A semiconductor memory including memory cells each connected to one of a first set of lines for selecting column address signal and to one of a second set of lines for selecting a row address signal, decoder responsive to address signals and a switching signal for producing a column address selecting signal and switching control signal, sense amplifier drive control circuit responsive to the column address selecting signal for producing sense amplifier driving signals, sense amplifier circuit responsive to the sense amplifier driving signals and the column address signal for amplifying the column address signal in response to the sense amplifier driving signals, and switching device responsive to the amplified sense amplifier driving signals and the switching control signal for outputing the amplified sense amplifier driving signals to data lines. In this semiconductor memory, since the sense amplifier driving current can be made so small, the power supply peak current can be considerably reduced.

FIG. 1

## A SEMICONDUCTOR MEMORY OPERATING WITH A LOW PEAK CURRENT

### BACKGROUND OF THE INVENTION

1. Field of the Invention

This invention relates generally to semiconductor memories, and particularly to a semiconductor memory having sense amplifiers.

2. Prior Art

Recently, the capacity of a memory was rapidly increased. In such a large capacity memory, there is a problem of a power supply peak current in the operation thereof. This peak current is reduced by a method disclosed in "A 65ns CMOS DRAM with a Twisted Driveline Sense Amplifier, Katsuhiro et al. ISSCC 87, FEB. 25, 1987". However, in the case that the capacity of semiconductor memories become larger as 4Mbits and 16Mbits memories, the peak current becomes so large even if the method is applied thereto.

### SUMMARY OF THE INVENTION

The present invention has been developed in order to remove the above-described drawbacks inherent to the conventional semiconductor memory.

It is, therefore, an object of the present invention to provide a new and useful semiconductor memory in which the number of sense amplifiers activated at the same time is reduced thereby a power supply peak current can be effectively suppressed.

It is another object of the invention to provide a low power consumption semiconductor memory.

It is a further object of the invention to provide a semiconductor memory suitable for storing a video image signal.

In accordance with the present invention there is provided a semiconductor memory comprising: memory cells each connected to one of a first set of lines for selecting column address signal and to one of a second set of lines for selecting a row address signal; decoder means responsive to address signals and a switching signal for producing a column address selecting signal and switching control signal; sense amplifier drive control circuit means responsive to the column address selecting signal for producing sense amplifier driving signals; sense amplifier circuit means responsive to the sense amplifier driving signals and the column address signal for amplifying the column address signal in response to the sense amplifier driving signals; and switching device means responsive to the amplified sense amplifier driving signals and the switching control signal for outputting the amplified sense amplifier driving signals to data lines.

In accordance with the present invention there is also provided a semiconductor memory comprising: memory cells each connected to one of a first set of lines for selecting column address signal and to one of a second set of lines for selecting a row address signal; decoder means responsive to address signals and a switching signal for producing a column address selecting signal and switching control signal; sense amplifier drive control circuit means responsive to the column address selecting signal for outputting sense amplifier driving signals and responsive to a sense amplifier control signal for outputting a sense amplifier drive control signal to stabilize data in the memory cell; sense amplifier circuit means responsive to the sense amplifier driving signals and the column address signal for amplifying the column address signal in response to the sense amplifier driving signals; and switching device means responsive to the amplified sense amplifier driving signals and the switching control signal for outputting the amplified sense amplifier driving signals to data lines.

In accordance with the present invention there is further provided a semiconductor memory comprising: a plurality of memory blocks including: memory cells each connected to one of a first set of lines for selecting column address signal and to one of a second set of lines for selecting a row address signal; decoder means responsive to address signals and a switching signal for producing a column address selecting signal and switching control signal; sense amplifier drive control circuit means responsive to the column address selecting signal for outputting sense amplifier driving signals and responsive to a sense amplifier control signal for outputting a sense amplifier drive control signal to stabilize data in the memory cell; sense amplifier circuit means responsive to the sense amplifier driving signals and the column address signal for amplifying the column address signal in response to the sense amplifier driving signals; and switching device means responsive to the amplified sense amplifier driving signals and the switching control signal for outputting the amplified sense amplifier driving signals to data lines; a row predecoder responsive to row address signals for outputting address signals and block selecting signal; and a block selecting circuit means responsive to the block selecting signals for determining one of the memory block.

## BRIEF DESCRIPTION OF THE DRAWINGS

The object and features of the present invention will become more readily apparent from the following detailed description of the preferred embodiment taken in conjunction with the accompanying drawings in which:

Fig. 1 is a block diagram of a semiconductor memory of a first embodiment according to the present invention;

Fig. 2 is a circuit diagram of a sense amplifier of Fig. 1;

Fig. 3A is a circuit diagram of a sense amplifier control circuit and a column decoder of Fig. 1;

Fig. 3B is a circuit diagram of a column address selecting circuit of Fig. 3A;

Fig. 4 is a circuit diagram showing another sense amplifier drive control circuit;

Fig. 5 is a graph showing power supply peak currents in conventional sense amplifier drive control circuits and in the present invnetion sense amplifier drive control circuit;

Fig. 6 shows a block diagram of a semiconductor memory of the present invention as an integrated circuit design;

Fig. 7 is a block diagram of a semiconductor memory for video memory according to the present invention;

Fig. 8 is a block diagram of a semiconductor memory of another design according to the present invention;

Fig. 9A is a circuit diagram of a block selecting circuit of Fig. 8;

Fig. 9B is a circuit diagram of a predecoder of Fig. 8;

Fig. 10 shows a block diagram of a conventional semiconductor memory;

Fig. 11 is a circuit diagram of a conventional sense amplifier drive control circuit;

Fig. 12 is a circuit diagram of another conventional sense amplifier drive control circuit;

Fig. 13A is a timing chart showing operation of the conventional semiconductor memory; and

Fig. 13B is a graph showing power supply peak currents of conventional sense amplifier drive control circuits.

The same or corresponding elements and parts are designated at like reference numerals throughout the drawings.

## DETAILED DESCRIPTION OF THE INVENTION

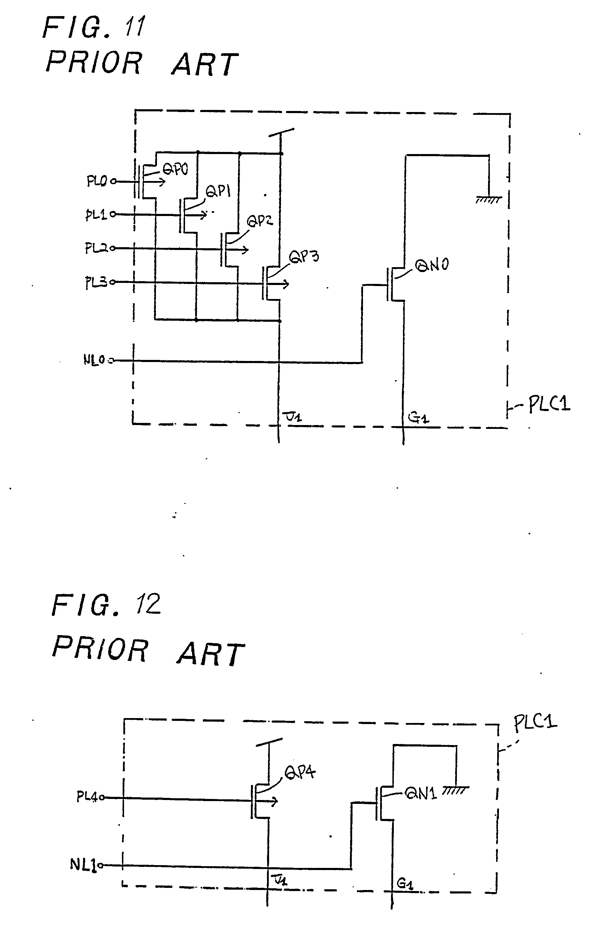

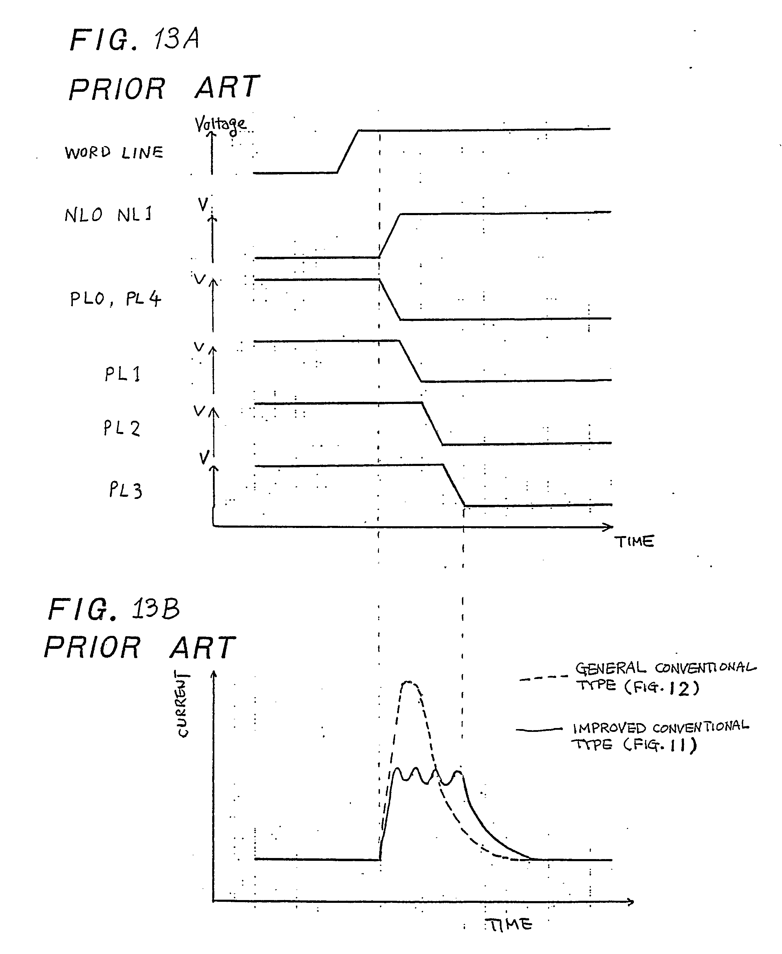

Prior to describing the preferred embodiments of the present invention, the above-mentioned conventional semiconductor memory will be described for a better understanding of the present invention with reference to Figs. 10, 11, 12, 13A, and 13B. Fig. 10 shows a block diagram of a dynamic random access memory (DRAM) as the conventional semiconductor memory; Fig. 11 is a circuit diagram of a conventional sense amplifier drive control circuit of Fig. 10; Fig. 12 is a circuit diagram of general conventional sense amplifier drive control circuit; Fig. 13A is a timing chart showing reading operation of the conventional semiconductor memory; and Fig. 13B is a graph showing power supply peak currents of the conventional sense amplifier drive control circuits where the time base thereof is the same as that of Fig. 13A.

Referring to Fig. 10, the conventioanl semiconductor memory generally comprises main amplifiers MA1 and MA2, sense amplifier drive control circuits PLC1 and PLC2, sense amplifiers SAR1, SAR2, ..., and SARn (n: natural number), and SAL1, SAL2, ..., and SALn, bit lines BR1, BR2, ..., and BRn, BR1$'$, BR2$'$, ..., and BRn, BL1, BL2, ..., and BLn, and BL1$'$, BL2$'$, ..., and BLn$'$, word lines WR1, WR2, ..., and WRn, and WL1, WL2, ..., and WLn, data lines D1, D1$'$, D2, and D2$'$, switching devices SWR1, SWR2, ..., and SWRn, and SWL1, SWL2, ..., and SWLn, switching control lines SWC1, SWC2, ..., and SWCn, memory cells C1, C2, ..., and Cn, and a column decoder CO. The bit lines BR1, BR1$'$, etc. are divided into a plurality of groups each having two bit lines, and each of the groups is respectively connected to the sense amplifiers SAR1, SAR2, etc. The memory cell Cn is connected to the word line WRp where p is odd and to the bit line BRn$'$, and the memory cell Cn$'$ is connected to the word line WRm where m is even and to the bit line BRn as shown in Fig. 10. The switching control line SWCn is connected to the swithing devices SWRn, SWRn$'$, SWLn, and SWLn$'$. The sense amplifiers SAR1, SAR2, ..., and SARn are connected to the data lines D1 and D1$'$ via the respective switching devices SWR1 and SWR1$'$, SWR2 and SWR2$'$, ..., SWRn and SWRn$'$, and the same amplifiers SAL1, SAL2, ..., and SALn are connected to the data lines D2 and D2$'$ via the respective switching devices SWR1 and SWR1$'$, SWR2 and SWR2$'$, ..., SWRn and SWRn$'$. It is to be noted that the sense amplifier drive control circuits PLC1 and PLC2 are respectively connected to all the sense amplifiers SARn, and all the sense amplifier SALn.

The data-reading operation of the conventional semiconductor memory having the above-mentioned structure will be described hereinbelow. Assuming that one line WR1 is selected, information of the memory cells C1, C2, ..., and Cn which are connected to such selected word line WR1 is respectively transmitted to the bit lines BR1', BR2', ..., and BRn' which are connected to such selected meory cells C1, C2, etc. Therefore, the information is sent to the sense amplifiers SAR1, SAR2, ..., and SARn. Then, all the sense amplifiers SAR1, SAR2, ..., and SARn are made active by the operation of the sense amplifier drive control circuit PLC1. Meanwhile, one of the switching control lines selected in the column decoder CO selects. In this case, the switching control line SWC1 connecting with the switching devices SWR1 and SWR1' is selected by the column decoder CO to transmit the information to the data lines D1 and D1'. After this, the information is sent to an output circuit (not shown) via the main amplifier MA1.

Fig. 12 shows a general sense amplifier drive control circuit including transistors QP4 and QN1. In Fig. 12, when one word line is selected, a signal L is inputted into an input terminal PL4, and a signal H is inputted into an input terminal NL1. Therefore, all sense amplifiers which are connected to the sense amplifier drive control circuit become active at the same time. In this sense amplifier drive control circuit, thus, the peak current at the onset of such a sense amplifier operation becomes large.

Fig. 11 shows a circuit diagram of an improved conventional sense amplifier drive control circuit having transistors QP0, QP1, QP2, QP3, and QN0, and Fig. 13A is a timing chart in the sense amplifier drive control circuit of Fig. 11. In Fig. 11, when one word line is selected, a signal L is inputted into only an input terminal PL0, and a signal H is inputted into an input terminal NL0 and input terminals PL1, PL2, and PL3. Then, a signal L is subsequently inputted into only the input terminal PL1, only the input terminal PL2, and only the input terminal PL3 at an interval. Accordingly, the current is applied to the sense amplifiers by stages so that the peak current can be reduced. As will be understood from the graph of Fig. 13 showing a peak current in these conventional sense amplifier drive control circuit of Figs. 11 and 12, the improved peak current is approximately 1/2 of the same in the general sense amplifier drive control circuit of Fig. 12.

However, in the case that the capacity of semiconductor memories become larger as 4Mbits and 16Mbits memories, the peak current becomes so large even in the above-mentioned conventional improved sense amplifier drive control circuit of Fig. 11.

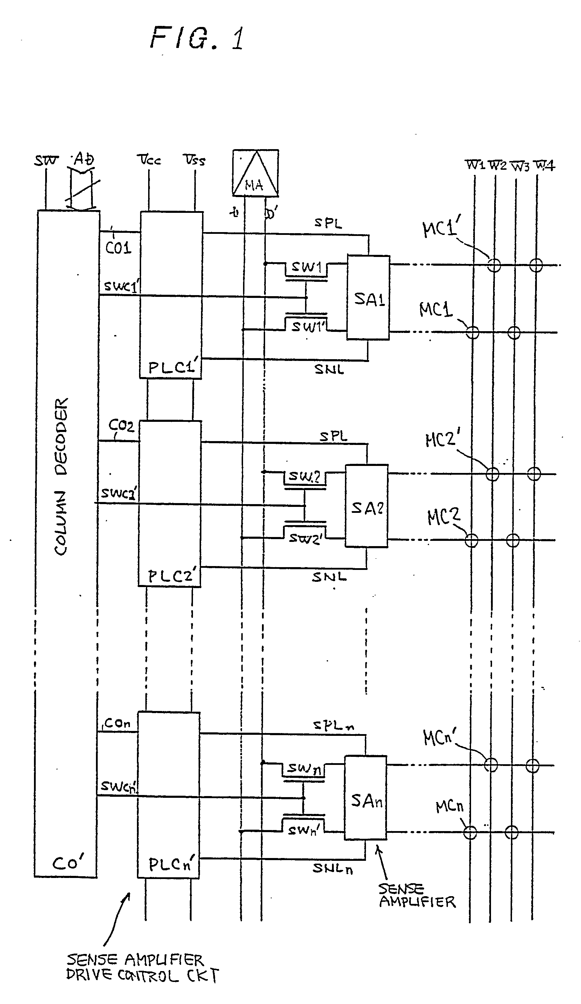

Referring now to Fig. 1, the semiconductor memory of a first embodiment of the present invention generally comprises a main amplifier MA, sense amplifier drive control circuits PLC1', PLC2', ..., and PLCn' each connected to a power supply line Vcc and a grand line Vss, sense amplifiers SA1, SA2, ..., and SAn (n: natural number), bit lines B1, B2, ..., and Bn, and B1', B2', ..., and Bn', ..., and Bn', word lines W1, W2, ..., data lines D, D' connected to the main amplifier MA, switching devices SW1, SW1', SW2, SW2', ..., SWn and SWn', switching control lines SWC1', SWC2', ..., and SWCn', memory cells MC1, MC2, ..., and MCn, and a column decoder CO'. The bit lines B1, B1', etc. are divided into a plurality of groups each having two bit lines Bn and Bn', and each of the groups is respectively connected to the sense amplifiers SA1, SA2, ..., SAn. The memory cell MCn is connected to the word line Wp' where p is odd and to the bit line Bn', and the memory cell MCn' is connected to the word line Wm where m is even and to the bit line Bn as shown in Fig. 1. The switching control line SWCn' is connected to the swithing devices SWn, SWn' for controlling the switching thereof. The sense amplifiers SA1, SA2, ..., and SAn are connected to the data lines D and D' via the respective switching devices SW1 and SW1', SW2 and SW2', ..., and SWn and SWn'. It is to be noted that the sense amplifier drive control circuits PLC1', PLC2', ..., and PLCn' are respectively connected to the sense amplifiers SA1, SA2, ..., and SAn via a pair of sense amplifier power lines SPLn and sense amplifier grand line SNLn. In other words, the sense amplifier SA1 has a power line SPL1 and a grand line SNL1, and the sense amplifier SA2 has a power line SPL2 and a grand line SNL2.

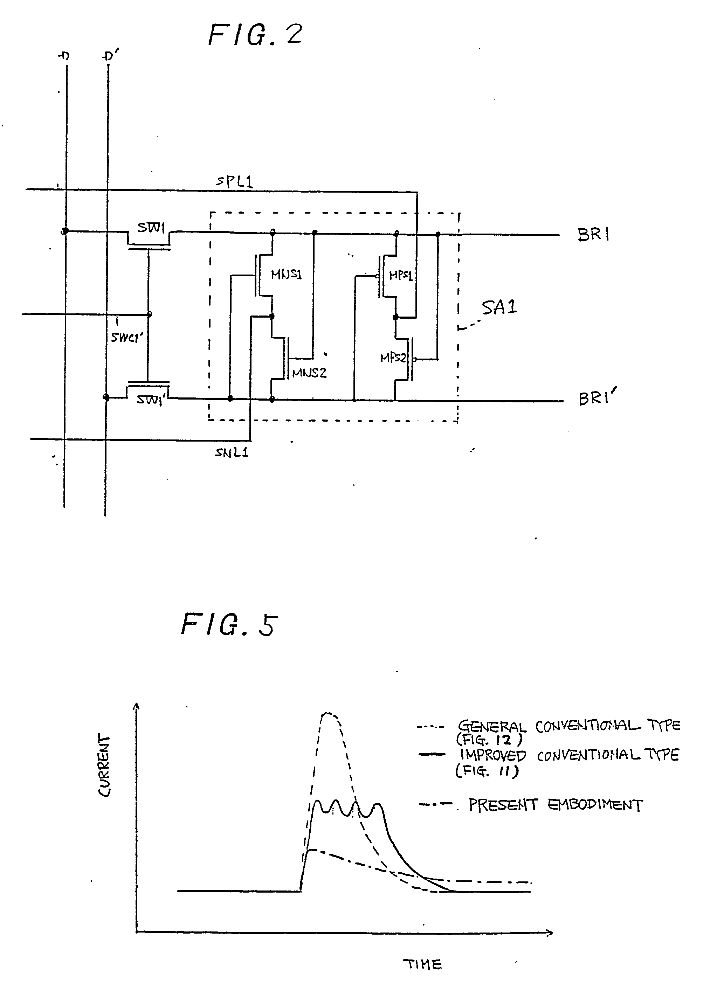

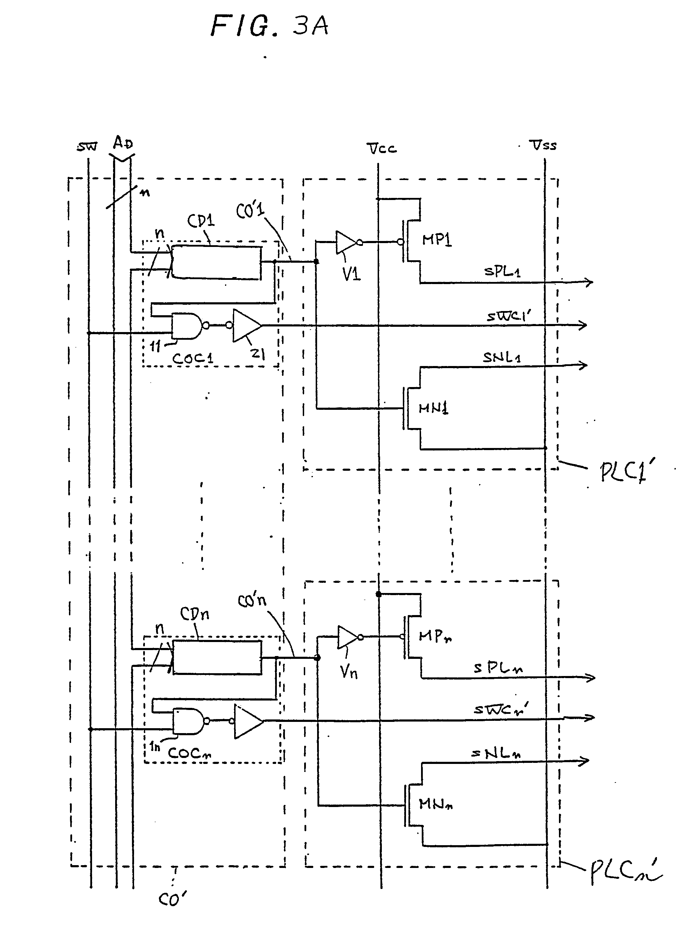

A circuit diagram of the sense amplifier SAn is shown in Fig. 2, and circuit diagrams of the sense amplifier drive control circuit PLCn' and the column decoder CO' are shown in Fig. 3A. In Fig. 2, the sense amplifier SA1 includes P-type metal oxide semiconductor transistors (PMOS transistors) MPS1 and MPS2 and N-type metal oxide semiconductor transistors (NMOS transistors) MNS1 and MNS2. In Fig. 3A, the sense amplifier drive control circuit PLCn includes a PMOS transistor MPn, an NMOS transistor MNn, and an inverter Vn. The PMOS transistors MP1, MP2, ..., and MPn are connected to the power supply line Vcc, and the NMOS transistos MN1, MN2, ..., and MNn are connected to the grand line Vss. The column decoder CO' includes column address control circuits COC1, ..., and COCn each having a column address selecting circuit, and a NAND gate and an inverter. For example, the column decoder COC1 includes a column address selecting circuit CD1, a NAND gate 11, and an inverter 12. The column address selecting circuits CD1, CD2, ..., and CDn are connected to address lines AD, and the NAND gates 11, ..., 1n are connected to a switching signal line SW. An output signal from the column address selecting circuits CD1, CD2, ..., and CDn is respectively inputted into the corresponding NAND gate 11, etc. The switching signal on the switching signal line SW becomes high for a predetermined time period in every writing operation.

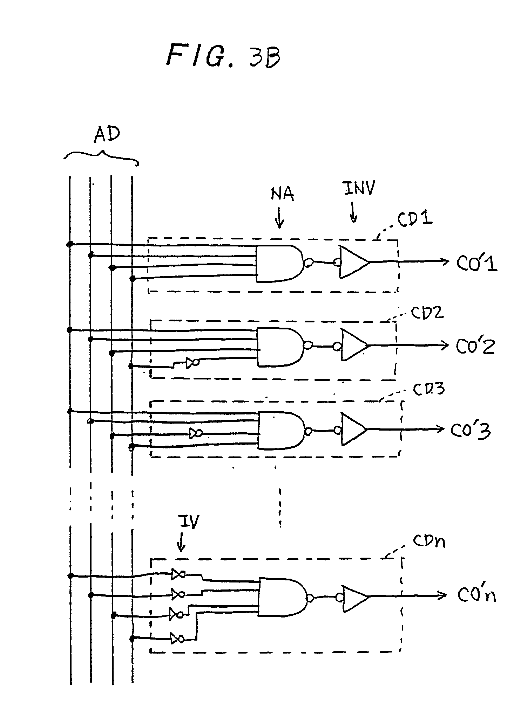

Fig. 3B shows a circuit diagram of the column address selecting circuit of Fig. 3A. Each of the column address selecting circuits CD1, CD2, ..., and CDn includes a NAND gate NA and an inverter INV. In the input of the NAND gate NA, only one address is determined by the number of inverter IV. Thus, in the column address selecting circuit CD1, CD2, ..., and CDn, one column address output signal $CO'$ is outputted in accordance with the address signals on the address lines AD. In Fig. 3B, there are twenty-four kinds of column address because the number of address lines n is 4.

The data-reading operation of the present semiconductor memory having the above-mentioned structure will be described hereinbelow with reference to Figs. 1, 2, and 3. In the data-reading operation, the bit lines B1, $B1'$, B2, $B2'$, ..., and $Bn'$ are determined at the same voltage level at first. Here, assuming that a word line W1 is selected, information of the memory cells MC1, MC2, ..., and MCn which are connected to such a selected word line W1 is respectively transmitted to the bit lines $B1'$, $B2'$, ..., and $Bn'$ which are connected to such selected meory cells MC1, MC2, etc. Therefore, the information is sent to the sense amplifiers SA1, SA2, ..., and SAn. At this time, if the column address 1 is selected by the column address control circuit COC1, a column address selecting signal $CO'1$ is outputted to the sense amplifier drive control circuit $PLC1'$, and a switching control signal is also produced by the COC1 for outputting to the switching devices SW1 and $SW1'$ via the switching control line $SWC1'$. In the sense amplifier drive control circuit $PLC1'$, the MOS transistors MP1 and MN1 are driven by the column address selecting signal $CO'1$ so that the sense amplifier driving signals are supplied, via the sense amplifier power supply line SPL1 and the sense amplifier grand line SNL1, to the sense amplifier SA1. In the sense amplifier SA1, the MOS transistors MNS1, MNS2, MPS1, and MPS2 are driven by the sense amplifier driving signals whereby the information on the bit lines B1 and $B1'$ is amplified and sent to the switching devices SW1 and $SW1'$. Sinse the switching devices SW1 and $SW1'$ are made active by the switching control signal via the switching control line $SWC1'$, the information on the bit line B1 is transmitted to the data line D, and the information on the bit line $B1'$ is transmitted to the data line $D'$. The transmitted informaiton on the data lines D and $D'$ is thus applied to the main amplifier MA.

As will be understood from the above description, only one sense amplifier SA1 is made active so that the power supply peak current can be considerably reduced in the semiconductor memory structure of the present invention.

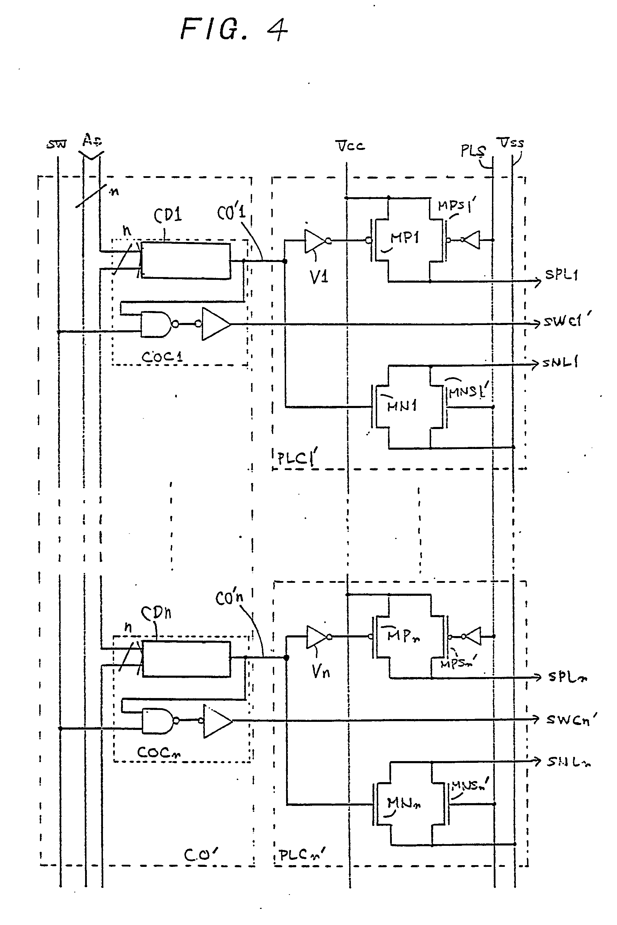

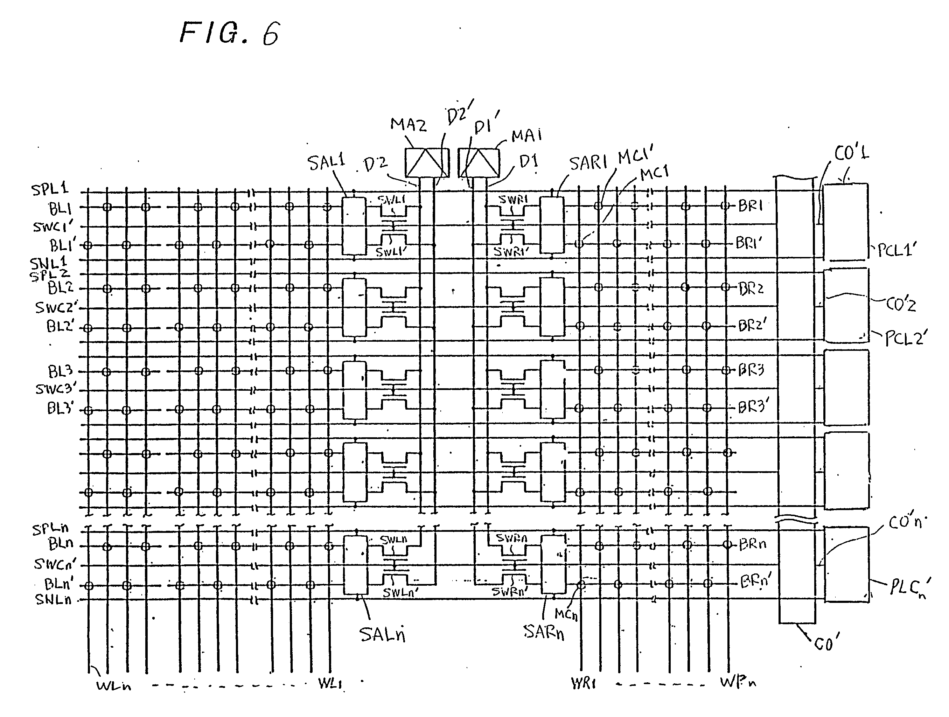

Fig. 4 is a circuit diagram showing another sense amplifier drive control circuit according to a second embodiment of the present invention. The sense amplifier drive control circuit of Fig. 4 has substantially the same structure as that of Fig. 3 except that MOS transistors $MPS1'$, ..., and $MPSn'$ are further provided in the sense amplifier drive control circuits $PLC1'$, ..., and $PLCn'$, and that a sense amplifier control signal line PLS is also provided so as to be connected to the MOS transistors $MPS1'$, ..., and $MPSn'$. In the sense amplifier control signal line PLS, a control signal in which a word line selecting signal (not shown) selecting word line W1, W2, ..., and Wn is delayed is applied. In Fig. 4, PMOS transistors $MPS1'$, ..., and $MPSn'$ are respectively connected, via the inverters IS1, .., and ISn, to control signal line PLS. The power supply line Vcc is connected, via the PMOS transistors MP1 and $MPS1'$, to the grand line Vss. Such improvement is provided for the stabilization of data in a memory cell. In other words, the control signal on the control line signal PLS becomes high when one of the word lines W1, W2, ..., and Wn is selected, so that all MOS transistors $MPS1'$, $MNS1'$, $MPS2'$, $MNS2'$, ..., and $MNSn'$ are made active. Accordingly, all sense amplifiers SA1, SA2, ..., and SAn are made active via the sense amplifier driving signals SPL1 and SNL1. Since the MOS transistos $MPS1'$, $MNS1'$, ..., and $MNSn'$ can be designed much smaller than the MOS transistors MP1, MN1, MP2, MN2, ..., and MNn, total power supply current of the sense amplifiers SA1, ..., and SAn. Therefore, a peak current thereof is further reduced in comparison with the conventional improved sense amplifier drive control circuit as shown in Fig. 5. Although Fig. 5 shows only current curves, voltage curves of Fig. 13A may be used in combination with Fig. 5. Whe using Fig. 13A in combination with Fig. 5, the voltage curve NL0, NL1 also indicates a voltage PLS in Fig. 4. Thus, in the present invention, the peak current is approximately 1/4 of the general conventional semiconductor memory.

In addition, when the signal $CO'1$ is applied to the PMOS transistor MP1 and NMOS transistor MN1, although the sense amplifier driving signals are sent to the sense amplifier circuit SA1 via the sense amplifier driving lines SPL1 and SNL1, the current amount thereof is negligible in the scale of Fig. 5.

Fig. 6 shows a block diagram of a semiconductor memory of the invention as an integrated circuit design. In Fig. 6, the data lines D1, D1', D2, and D2' and the word lines WR1, WL1, WR2, WL2, ..., and WL2 are provided so as to be made normal to the bit lines B1, B1', B2, B2', ..., and Bn'. The sense amplifier driving lines SPL1, SNL1, ..., and SNLn are provided so as to be made parallel to the bit lines B1, B1', B2, B2', ..., and Bn'. Moreover, the bit lines B1, B1', ..., and Bn' is formed in a first layer; the word lines WR1, WL1, ..., and WLn and the data lines D1, D1' D2, and D2' are formed in a second layer; and the sense amplifier driving lines SPL1, SNL1, ..., and SNLn are formed in a third layer. Therefore, since the sense amplifiers having the same column address can be connected to the same sense amplifier driving lines, an efficient layout can be achieved.

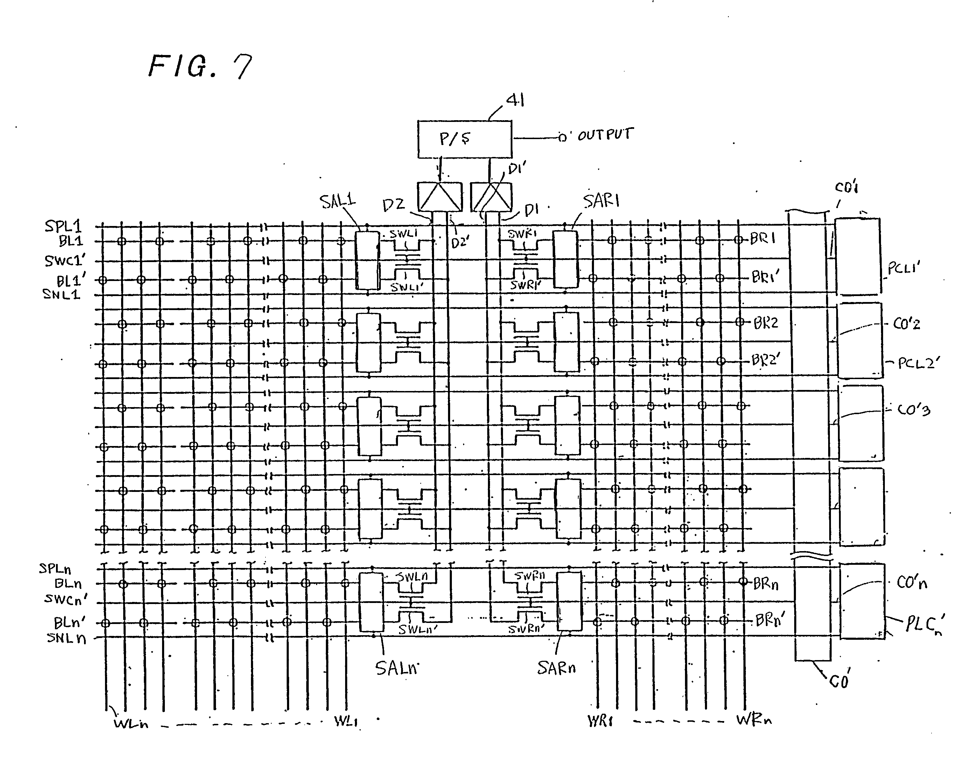

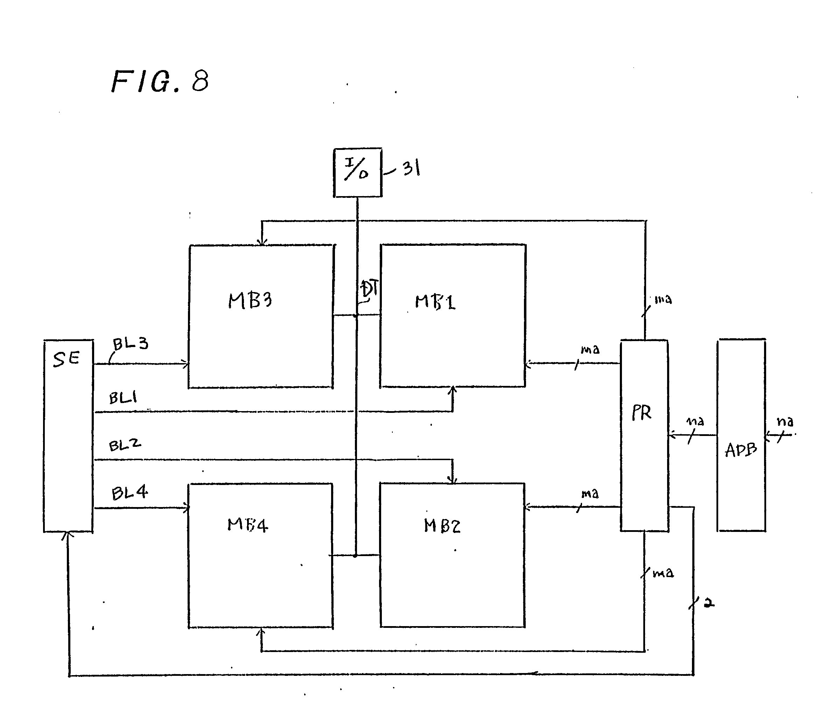

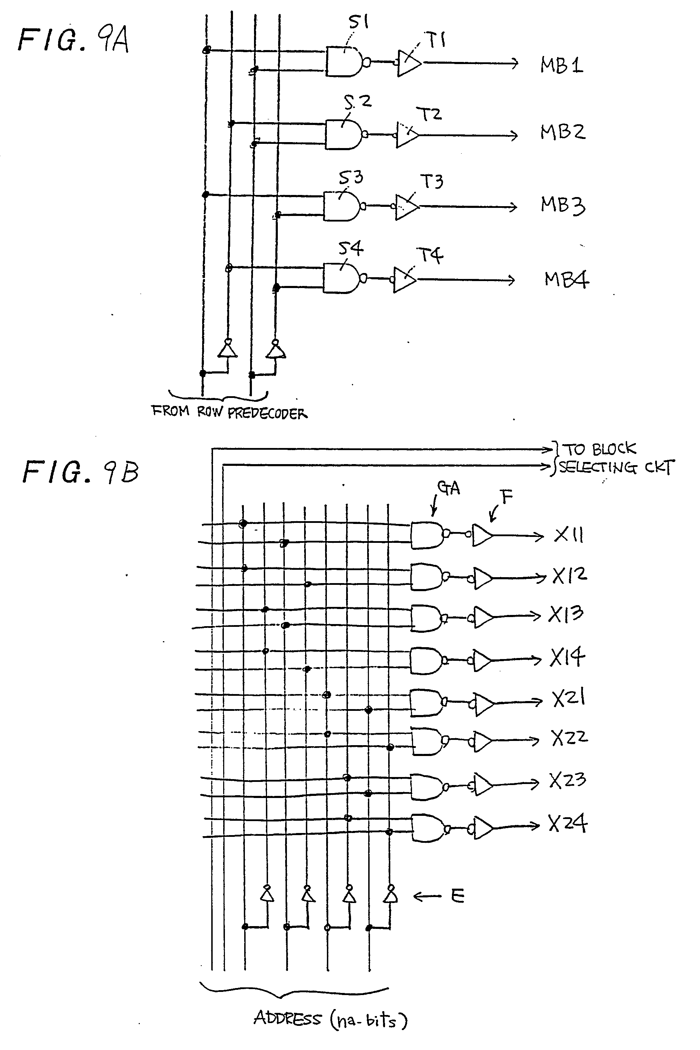

Fig. 7 is a block diagram of a semiconductor memory suitable for a video memory according to the invention. The semiconductor memory of Fig. 7 has substantially the same structure as that of Fig. 6 except that a parellel-to-serial converting circuit 41 is provided so as to be arranged between the main amplifiers MA1 and MA2 and an output circuit (not shown).

Although the cycle time in a memory operation is not short in the structure of the present invention due to small applied current thereto, the present semiconductor memory can be applied to a video memory in which column address data is subsequently inputted therein or outputted therefrom.

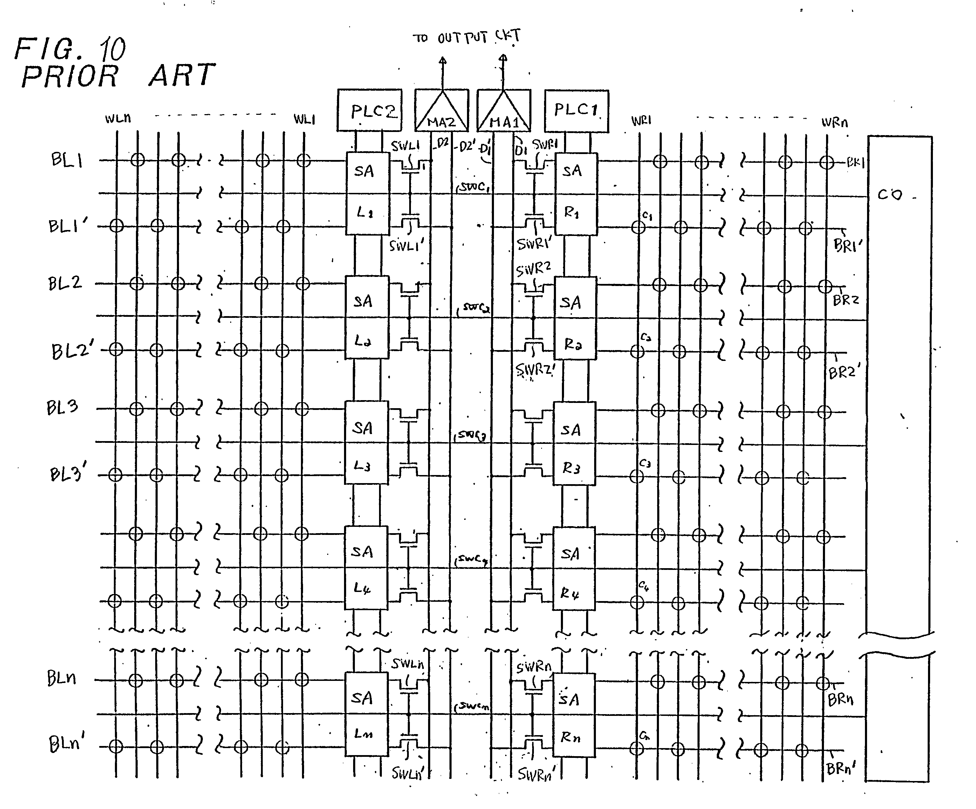

Fig. 8 is a block diagram of a semiconductor memory of another design according to the present invention. In Fig. 8, the semiconductor memory comprises four memory blocks MB1, MB2, MB3, and MB4, an input/output port 31, an address input buffer ADB, a row predecoder PR, and a block selecting circuit SE. Fig. 9A is a circuit diagram of the block selecting circuit includes four NAND gates S1, S2, S3, and S4 respectively connected to four inverters T1, T2, T3, and T4, and produced block signals BL1, BL2, BL3, and BL4 are respectively sent to the memory blocks MB1, MB2, MB3, and MB4 for making active only one memory block. Fig. 9B shows a circuit diagram of the row predecoder when the number of address line na is 6. In Fig. 9B, the row predecoder PR includes NAND gates GA and invereters E and F each connected to the corresponding NAND gate GA. Each of the memory blocks MB1, MB2, MB3, and MB4 has the same structure of the semiconductor design of Fig. 1 except that a row decoder (not shown) is provided between word lines WR1, WL1, ..., and WLn and the row predecoder PR. The output signal from the parallel-to-serial converting circuit 41 is sent to a data line DT, and then transmitted to the input/output port 31. Address signals of an na-bits is inputted, via the address input buffer ADB, to the row predecoder PR. In Fig.

9B, two bit-lines for selecting the memory blocks MB1 to MB4 are connected to the block selecting circuit SE, and produced signals on ma-lines X11, X12, X13, X14, X21, X22, X23, and X24 which are formed of 2(na-2) bit-lines are sent to the memory blocks MB1, MB2, MB3, and MB4 by means of the remaining bit-lines, i.e. (na-2) bit-lines in the inputted address lines of the row predecoder PR. In each of the memory blocks MB1, MB2, MB3, and MB4, by the combination of one of such four lines X11, X12, X13, and X14 and one of such four lines X21, X22, X23, and X24, sixteen address lines can be respectively connected to the word lines WR1, WL1, ..., and WL8 in total.

As will be understood from the above description, since the sense amplifier driving current is so small, the power supply peak current can be considerably reduced in the semiconductor memory structure of the present invention. In the above-mentioned structure of the memory blocks MB1 to MBn, the time for designing such semiconductor memories can be also reduced.

The above-described embodiments are just examples of the present, and therefore, it will be apparent for those skilled in the art that many modifications and variations may be made without departing from the scope of the present invention.

A semiconductor memory including memory cells each connected to one of a first set of lines for selecting column address signal and to one of a second set of lines for selecting a row address signal, decoder responsive to address signals and a switching signal for producing a column address selecting signal and switching control signal, sense amplifier drive control circuit responsive to the column address selecting signal for producing sense amplifier driving signals, sense amplifier circuit responsive to the sense amplifier driving signals and the column address signal for amplifying the column address signal in response to the sense amplifier driving signals, and switching device responsive to the amplified sense amplifier driving signals and the switching control signal for outputing the amplified sense amplifier driving signals to data lines. In this semiconductor memory, since the sense amplifier driving current oan be made so small, the power supply peak current can be considerably reduced.

## Claims

1. A semiconductor memory comprising:

(a) memory cells each connected to one of a first set of lines for selecting column address signal and to one of a second set of lines for selecting a row address signal;

(b) decoder means responsive to address signals and a switching signal for producing a column address selecting signal and switching control signal;

(c) sense amplifier drive control circuit means responsive to said column address selecting signal for producing sense amplifier driving signals;

(d) sense amplifier circuit means responsive to said sense amplifier driving signals and said column address signal for amplifying said column address signal in response to said sense amplifier driving signals; and

(e) switching device means responsive to said amplified sense amplifier driving signals and said switching control signal for outputting said amplified sense amplifier driving signals to data lines.

2. A semiconductor memory as claimed in Claim 1, wherein said decoder means includes a number of column address control circuit each having a column address selecting circuit and a NAND gate.

3. A semiconductor memory as claimed in Claim 1, wherein said sense amplifier drive control circuit means includes two MOS transistors for applying said sense amplifier driving signals to said sense amplifier circuit means.

4. A semiconductor memory as claimed in Claim 1, wherein said sense amplifier circuit means includes four MOS transistors for amplifying said column address signal in response to said sense amplifier driving signals.

5. A semiconductor memory as claimed in Claim 1, wherein said sense amplifier driving signals are sent from said sense amplifier drive control circuit means to said sense amplifier circuit means via sense amplifier driving signal lines which are provided so as to be made parallel to said first set of lines.

6. A semiconductor video memory comprising:

(a) memory cells each connected to one of a first set of lines for selecting column address signal and to one of a second set of lines for selecting a row address signal;

(b) decoder means responsive to address signals and a switching signal for producing a column address selecting signal and switching control signal;

(c) sense amplifier drive control circuit means responsive to said column address selecting signal for producing sense amplifier driving signals;

(d) sense amplifier circuit means responsive to said sense amplifier driving signals and said column address signal for amplifying said column address signal in response to said sense amplifier driving signals, said sense amplifier driving signals being sent from said sense amplifier drive control circuit means to said sense amplifier circuit means via sense amplifier driving signal lines which are provided so as to be made parallel to said first set of lines; and

(e) switching device means responsive to said amplified sense amplifier driving signals and said switching control signal for outputting said amplified sense amplifier driving signals to data lines.

7. A semiconductor memory comprising:

(a) memory cells each connected to one of a first set of lines for selecting column address signal and to one of a second set of lines for selecting a row address signal;

(b) decoder means responsive to address signals and a switching signal for producing a column address selecting signal and switching control signal;

(c) sense amplifier drive control circuit means responsive to said column address selecting signal for outputting sense amplifier driving signals and responsive to a sense amplifier control signal for outputting a sense amplifier drive control signal to stabilize data in said memory cell;

(d) sense amplifier circuit means responsive to said sense amplifier driving signals and said column address signal for amplifying said column address signal in response to said sense amplifier driving signals; and

(e) switching device means responsive to said amplified sense amplifier driving signals and said switching control signal for outputing said amplified sense amplifier driving signals to data lines.

8. A semiconductor memory comprising:

(a) a plurality of memory blocks including: memory cells each connected to one of a first set of lines for selecting column address signal and to one of a second set of lines for selecting a row address signal;

decoder means responsive to address signal and a switching signal for producing a column address selecting signal and switching control signal;

sense amplifier drive control circuit means responsive to said column address selecting signal for outputting sense amplifier driving signals and responsive to a sense amplifier control signal for outputting a sense amplifier drive control signal to stabilize data in said memory cell;

sense amplifier circuit means responsive to said sense amplifier driving signals and said column address signal for amplifying said column address signal in response to said sense amplifier driving signals; and

switching device means responsive to said amplified sense amplifier driving signals and said switching control signal for outputing said amplified sense amplifier driving signals to data lines;

(b) a row predecoder responsive to row address signals for outputting address signals and block selecting signal; and

(c) a block selecting circuit means responsive to said block selecting signals for determining one of said memory block.

# FIG. 1

# FIG. 2

D   D'

SPL1

SW1

SWC1'

SW1'

SNL1

BRI

MNS1      HPS1

SA1

MNS2      MPS2

BRI'

# FIG. 5

CURRENT

TIME

----- GENERAL CONVENTIONAL TYPE (FIG. 12)

——— IMPROVED CONVENTIONAL TYPE (FIG. 11)

—·—· PRESENT EMBODIMENT

# FIG. 3A

# FIG. 3B

# FIG. 4

FIG. 6

FIG. 7

FIG. 8

FIG. 9A

FROM ROW PREDECODER

FIG. 9B

TO BLOCK
SELECTING CKT

ADDRESS (na-bits)

FIG. 10
PRIOR ART

TO OUTPUT CKT

## FIG. 11
## PRIOR ART

## FIG. 12
## PRIOR ART

## FIG. 13A
## PRIOR ART

Voltage

WORD LINE

NLO NL1    V

PLO, PL4    V

PL1    V

PL2    V

PL3    V

TIME

## FIG. 13B
## PRIOR ART

CURRENT

----- GENERAL CONVENTIONAL
TYPE (FIG. 12)

——— IMPROVED CONVENTIONAL
TYPE (FIG. 11)

TIME